# EUROPEAN PATENT APPLICATION

(11) **EP 2 682 991 A2**
(43) Date of publication of application: **08.01.2014**
(21) Application number: 13184135.5
(22) Date of filing: 14.11.2006
(51) Int. Cl.: H01L 31/048, H01L 31/0216, H01B 3/44, C09D 127/18, C09D 133/08, C09D 131/02

(54) **Coating composition for protection cover of solar cell**

(30) Priority: 30.11.2005 JP 2005346730; 22.03.2006 JP 2006078179
(62) Divisional of application: 06832597.6
(71) Applicant: DAIKIN INDUSTRIES, LIMITED, Osaka-shi Osaka 530 (JP)
(72) Inventor: Nagato, Masaru, Osaka, 566-8585 (JP); Maeda, Masahiko, Osaka, 566-8585 (JP); Kato, Masami, Osaka, 566-8585 (JP); Higuchi, Tatsuya, Osaka, 566-8585 (JP); Mukai, Eri, Osaka, 566-8585 (JP); Higashiura, Tadashi, Osaka, 566-8585 (JP)
(74) Representative: HOFFMANN EITLE

(57) **Abstract**

The invention provides a solar cell comprising
- a solar cell module (I) and,
provided on the sunlight irradiation side of the module (I) in this order,
- a transparent resin layer (II),
- optionally a primer layer (IV), and
- a top coat layer (III) which is a cured layer of a coating composition comprising (A) a curable fluorine-containing resin, (B) a curing agent and (C) a solvent.

## Description

### TECHNICAL FIELD

The present invention relates to a protection cover of solar cell being excellent in transparency, solvent resistance, water resistance (moisture impermeability), weather resistance, durability, coating film hardness and gloss and being produced in due consideration of environment, and relates to a curable fluorine-containing coating composition used for forming the protection cover.

### BACKGROUND ART

Currently a glass sheet is used on a protection cover of solar cell. However, since glass is heavy and fragile, there are proposed sheets made of transparent resins such as a polycarbonate sheet and an acrylic resin sheet being light, transparent and high in a refractive index as a substrate replacing the glass sheet. These transparent resin sheets are inferior in weather resistance, chemical resistance, scratch resistance and stain-proofing property, and have not yet replaced glass sheets.

On the other hand, a fluorine-containing resin has excellent weather resistance, chemical resistance, water- and oil-repelling property and stain-proofing property and low refractive index, which are derived from high energy and low polarization of C-F bond in its molecule, and is used in various applications. Therefore, it can be considered that weather resistance, transparency, chemical resistance, water- and oil-repelling property and stain-proofing property can be improved if a fluorine-containing resin layer can be formed on a surface of a transparent resin substrate.

For forming a fluorine-containing resin layer on a surface of a transparent resin substrate, generally there are a method of sticking a fluorine-containing resin film and a method of coating a fluorine-containing resin coating composition. From the viewpoint of easiness in forming work, post-processability and applicability to coating on a substrate having complicated shape, the coating method is preferable.

Examples of a well-known fluorine-containing resin coating composition used for a coating method are coating compositions comprising polytetrafluoroethylene (PTFE) as used for coating on a frying pan for giving oil repellency, but they cannot be applied to resin substrates because high temperature baking is necessary for forming a coating film.

Examples of known transparent cold curing fluorine-containing resins are copolymers of fluoroolefin with various hydrocarbon monomers, which are soluble in organic solvents and can be cured for forming a coating film at room temperature. However, since fluorine-containing resins have characteristics such as excellent solvent resistance, strong solvents such as ketone solvents and ester solvents dissolving not only fluorine-containing resins but also other resins must be used.

For example, JP57-34107A discloses a copolymer of fluoroolefin, alkyl vinyl ether and hydroxyalkyl vinyl ether as a curable coating composition having weather resistance. Also, copolymers of fluoroolefin, vinyl ester, alkyl vinyl ether and hydroxyalkyl vinyl ether are disclosed as a curable fluorine-containing resin for a curable coating composition in JP61-275311A, JP62-7767A, JP3-121107A and JP6-184243A. In addition, JP6-271807A proposes a curable fluorine-containing resin having good adhesion to polycarbonate, etc.

However, though these fluorine-containing copolymers are dissolved in strong solvents, they are hardly dissolved in general purpose solvents, especially weak solvents having less capability of dissolving resins such as 3rd class organic solvents (provided in Japanese Organic Solvent Toxicity Prevention Regulation).

When a strong solvent-based fluorine-containing resin coating composition is applied to a transparent resin substrate, the resin substrate is melted and transparency (light transmission) of the transparent resin substrate is remarkably lowered. Such a coating composition is effective as coatings for general building materials and internal parts of equipment and electric appliances for which high transparency is not required, but its application to a protection cover of solar cell requiring light transmission as most important characteristic has been postponed.

While fluorine-containing resin coating compositions prepared using a weak solvent and not melting a transparent resin substrate are desired, curable fluorine-containing resins being dissolved in weak solvents are not known so much.

For example, as a result of studies on solvents, a non-curable fluorine-containing resin comprising fluoroolefin and cyclohexyl vinyl ether and being soluble in mineral spirit (3rd class organic solvent) is disclosed in JP53-96088A, and a curable fluorine-containing resin being soluble in mineral spirit is disclosed in JP8-32847B.

However, though these fluorine-containing resins are soluble in general purpose solvents, even in the case of a curable fluorine-containing copolymer of JP8-32847B, a sum of a hydroxyl value and an acid value is up to 30 mgKOH/g, and any of hydroxyl value and acid value of copolymers which are confirmed to be soluble in mineral spirit in examples thereof are as small as 5 mgKOH/g. Therefore, curability is insufficient, and improvement in solvent resistance, weather resistance and durability which are advantageous characteristics of fluorine-containing resins cannot be expected.

On the other hand, in the field of solar cell, JP59-198773A proposes use of a fluorine-containing resin coating on a protection cover of solar cell. However, since the fluorine-containing resin coating film is formed directly on a solar cell module, there is a problem with strength as a protection cover.

JP2-123771A proposes use of a fluorine-containing resin having a fluorine-containing aliphatic ring structure on a solar cell. However, in this fluorine-containing resin, introduction of cure site is difficult, and it cannot be said that improvement in solvent resistance, weather resistance and durability is satisfactory.

### DISCLOSURE OF INVENTION

It is an object of the present invention to provide a protection cover of solar cell having processability at room temperature, solvent resistance, weather resistance and durability without impairing transparency of the cover, and a curable fluorine-containing resin coating composition being capable of forming the protection cover.

Namely, the present invention relates to a curable fluorine-containing resin coating composition for a protection cover of solar cell comprising (A) a curable fluorine-containing resin, (B) a curing agent and (C) a solvent and being used for forming a top coat layer (III) of a cured fluorine-containing resin to be provided, directly or via a primer layer (IV), on a transparent resin layer (II) provided on the sunlight irradiation side of a solar cell module (I).

Also, the present invention relates to a solar cell comprising a solar cell module (I), a transparent resin layer (II) provided on the sunlight irradiation side of the module and a top coat layer (III) provided on the transparent resin layer directly or via a primer layer (IV), in which the top coat layer (III) is a cured layer of the above-mentioned coating composition for a protection cover, and further relates to a laminated film for a protection cover of solar cell comprising a transparent resin layer (II) and a top coat layer (III) provided on the transparent resin layer directly or via a primer layer (IV) and being provided on the sunlight irradiation side of a solar cell module (I), in which the top coat layer (III) is a cured layer of the above-mentioned curable fluorine-containing coating composition.

### BEST MODE FOR CARRYING OUT THE INVENTION

The coating composition for a protection cover of solar cell of the present invention is used for forming the top coat layer (III) of a cured fluorine-containing resin to be provided, directly or via a primer layer (IV), on the transparent resin layer (II) provided on the sunlight irradiation side of the solar cell module (I).

The coating composition for a protection cover is a curable fluorine-containing coating composition comprising (A) the curable fluorine-containing resin, (B) the curing agent and (C) the solvent.

Next, each component is explained below.

### (A) Curable fluorine-containing resin

In the present invention, a fluorine-containing resin having curable group used alone or a blend of a fluorine-containing resin having curable group and a non-curable fluorine-containing resin and/or a curable or non-curable non-fluorine-containing resin may be used as the curable fluorine-containing resin. In addition, a blend of a non-curable fluorine-containing resin and a curable non-fluorine-containing resin may be used.

Examples of a curable fluorine-containing resin are as follows.

(A1) Curable fluorine-containing resins dissolving in weak solvents, especially 3rd class organic solvents:
There are copolymers comprising a fluoroolefin unit, a vinyl ether unit and a monomer unit having a cure site and copolymers comprising a fluoroolefin unit, a vinyl ester unit and a monomer unit having a cure site.

Examples of fluoroolefins are, for instance, tetrafluoroethylene (TFE), hexafluoropropylene (HFP), chlorotrifluoroethylene (CTFE), perfluoro(alkyl vinyl ether) (PAVE), trifluoroethylene (TrFE), vinylidene fluoride (VdF) and ethylene fluoride.

Examples of vinyl ethers are, for instance, ethyl vinyl ether, cyclohexyl vinyl ether, methyl vinyl ether, n-butyl vinyl ether, 2-ethylhexyl vinyl ether, isobutyl vinyl ether and 2-methoxyethyl vinyl ether.

Examples of vinyl esters are, for instance, vinyl versatate (VEOVA9 and VEOVA10 available from Shell Chemical), vinyl benzoate, vinyl acetate, vinyl propionate, vinyl butyrate, vinyl pivalate, vinyl caproate and vinyl p-t-butylbenzoate.

Examples of a monomer having a cure site are hydroxyl-containing monomers, for instance, hydroxyalkyl vinyl ethers such as hydroxybutyl vinyl ether (HBVE) and hydroxypropyl vinyl ether; hydroxyalkyl allyl ethers such as 2-hydroxyethyl allyl ether and 4-hydroxybutyl allyl ether; and hydroxyalkyl vinyl esters such as hydroxyethyl vinyl ether, and carboxyl-containing structural units, for instance, acrylic acid, methacrylic acid, vinylacetic acid, crotonic acid, undecylenic acid, maleic acid, maleic acid monoester, maleic anhydride, fumaric acid and fumaric acid monoester. In addition, a silane-containing monomer such as vinyl silane, an epoxy-containing monomer and an amino-containing monomer can be used.

Specifically, there are, for example, TFE/VEOVA9/vinyl benzoate/hydroxybutyl vinyl ether copolymer, CTFE/ethyl vinyl ether/cyclohexyl vinyl ether/hydroxybutyl vinyl ether copolymer and the like.

It is preferable that this curable fluorine-containing resin is a hydroxyl-containing fluorine-containing copolymer having a hydroxyl value of more than 5 mgKOH/g and a sum of hydroxyl value and acid value of more than 30 mgKOH/g, from the viewpoint of satisfactory solubility in weak solvents and excellent curing reactivity. The hydroxyl value is preferably not less than 10 mgKOH/g, especially preferably not less than 30 mgKOH/g, from the viewpoint of improvement in curing reactivity, and is preferably not more than 65 mgKOH/g, especially preferably not more than 60 mgKOH/g, from the viewpoint of solubility in weak solvents.

When the hydroxyl value is not more than 5 mgKOH/g, there is a tendency that curability is lowered, and solvent resistance, weather resistance, durability, chemical resistance, hardness of a coating film and adhesion become insufficient.

Even when the curable fluorine-containing resin (A1) has an acid value, a sum of hydroxyl value and acid value is preferably more than 30 mgKOH/g. If the sum of hydroxyl value and acid value is not more than 30 mgKOH/g, there is a tendency that curability is lowered, and solvent resistance, weather resistance, durability, chemical resistance and adhesion become insufficient.

These curable fluorine-containing resins (A1) may be mixed with a non-fluorine-containing resin such as an acrylic resin or a urethane resin. This non-fluorine-containing resin may be either a curable resin or a non-curable resin.

Examples of an acrylic resin are those having been used for coating, for instance, homopolymers of alkyl esters of (meth)acrylic acid having 1 to 10 carbon atoms or copolymers thereof and copolymers of (meth)acrylic acid esters having curable functional group in a side chain and/or at an end of a trunk chain thereof. (A2) Curable fluorine-containing resins comprising tetrafluoroethylene (TFE) and hydrocarbon monomer (excluding the above-mentioned (A1)):
There are copolymers comprising a TFE unit, a hydrocarbon monomer unit, a vinyl ester unit and a monomer unit having cure site.

Examples of vinyl ester and monomer having cure site are those exemplified supra.

Examples of a hydrocarbon monomer are, for instance, ethylene, propylene, isobutylene, butylene, pentene, hexene, heptene and octene.

Examples thereof are TFE/isobutylene/vinyl benzoate/hydroxybutyl vinyl ether copolymers, TFE/HFP/ethylene/vinyl benzoate/hydroxybutyl vinyl ether copolymers, and the like.

These curable fluorine-containing resins (A2) may be mixed with a non-fluorine-containing resin such as an acrylic resin or a urethane resin. This non-fluorine-containing resin may be a curable one or a non-curable one.

Examples of an acrylic resin are those exemplified supra. (A3) Curable fluorine-containing resins comprising chlorotrifluoroethylene (CTFE) (excluding the above-mentioned (A1)):
There are copolymers comprising a CTFE unit, a monomer unit having cure site, and further, if necessary, a hydrocarbon monomer unit and/or a vinyl ether unit.

Examples of a monomer having cure site, vinyl ether and a hydrocarbon monomer are those exemplified supra.

Examples thereof are CTFE/ethyl vinyl ether/hydroxybutyl vinyl ether copolymers, CTFE/ethylene / ethyl vinyl ether/ hydroxybutyl vinyl ether copolymers, and the like.

These curable fluorine-containing resins (A3) may be mixed with a non-fluorine-containing resin such as an acrylic resin or a urethane resin. This non-fluorine-containing resin may be a curable one or a non-curable one.

Examples of an acrylic resin are those exemplified supra. (A4) Curable fluorine-containing resins comprising vinylidene fluoride (VdF) (excluding the above-mentioned (A1)):
There are copolymers comprising a VdF unit, a monomer unit having cure site, and further, if necessary, a hydrocarbon monomer unit, a vinyl ester unit and/or a vinyl ether unit.

Examples of a monomer having cure site, vinyl ether, vinyl ester and a hydrocarbon monomer are those exemplified supra.

These curable fluorine-containing resins (A4) may be mixed with a non-fluorine-containing resin such as an acrylic resin or a urethane resin. This non-fluorine-containing resin may be a curable one or a non-curable one.

Examples of an acrylic resin are those exemplified supra. (A5) Curable fluorine-containing resins comprising non-curable fluorine-containing resin and curable non-fluorine-containing resin:
TFE copolymers, CTFE copolymers and VdF copolymers can be used as a non-curable fluorine-containing resin.

Examples of non-curable TFE resin are, for instance, TFE/ethylene/hexafluoropropylene copolymer, and the like.

Examples of non-curable CTFE resin are, for instance, CTFE/cyclohexyl vinyl ether copolymer, and the like.

Examples of non-curable VdF copolymers are, for instance, VdF/TFE/CTFE copolymers, VdF/TFE/HFP copolymers, VdF/HFP copolymers, VdF/CTFE copolymers, and the like.

Examples of curable non-fluorine-containing resin are a curable acrylic resin, a urethane resin and the like.

Examples of curable acrylic resin are those having been used for coating, and there are used preferably copolymers of (meth)acrylic acid ester having curable functional group in its side chain and/or at an end of its trunk chain.

Among these curable fluorine-containing resins (A), from the viewpoint that a solvent not attacking a transparent resin can be used and transparency and chemical resistance are satisfactory, the curable fluorine-containing resin (A1) is preferable, and further the curable fluorine-containing resin (A1) comprising TFE as fluoroolefin is especially preferable from the viewpoint of satisfactory weather resistance.

### (B) Curing agent

An optimum curing agent is selected depending on kind of a curable group of the curable fluorine-containing resin.

When the curable group is hydroxyl group, an isocyanate curing agent and an amino resin curing agent are suitable.

Nonlimiting examples of an isocyanate curing agent are, for instance, 2,4-tolylene diisocyanate, diphenylmethane-4,4'-diisocyanate, xylylene diisocyanate, isophorone diisocyanate, lysine methyl ester diisocyanate, methylcyclohexyl diisocyanate, trimethylhexamethylene diisocyanate, hexamethylene diisocyanate, n-pentane-1,4-diisocyanate, trimers thereof, adducts and biurets thereof, polymers thereof having at least two isocyanate groups, blocked isocyanates and the like.

Nonlimiting examples of an amino resin curing agent are, for instance, urea resin, melamine resin, benzoguanamine resin, glycoluril resin, methylolmelamine resin obtained by methylolation of melamine, alkyl-etherified melamine resin obtained by etherification of methylolmelamine with alcohol such as methanol, ethanol or butanol, and the like.

### (C) Solvent

The solvent may be one not attacking a transparent resin constituting the transparent resin layer (II), and a weak solvent is preferable from the viewpoint that it is easy to make a coating composition and drying property of a coating film and solubility of various additives are satisfactory.

Examples of weak solvents are, for instance, nonpolar organic hydrocarbon solvents such as 3rd class organic solvents (coal tar naphtha, mineral spirit, turpentine oil, petroleum naphtha, petroleum ether, petroleum benzene provided in Japanese Organic Solvent Toxicity Prevention Regulation), and in addition, alcohol and glycol solvents. Among these, from the viewpoint that it is easy to make a coating composition and drying property of a coating film and solubility of various additives are satisfactory, nonpolar organic hydrocarbon solvents, especially 3rd class organic solvents being general-purpose solvents, further coal tar naphtha and mineral spirit are preferable.

In addition, at least one of 1,4-dioxane, trichloroethylene, chloroform, aniline, pyridine, n-pentanol, acetonitrile, methyl ethyl ketone, acetone, butyl acetate, methyl acetate, dimethylformamide, benzyl alcohol, ethanol, methanol, 1-butanol, diethylene glycol, ethanolamine, ethylene glycol, formic acid and water may be used in consideration of an effect on the transparent resin layer, formation into a coating composition, drying property of a coating film, solubility of various additives and adhesion to a substrate, or may be used together with a weak solvent.

In the curable fluorine-containing resin composition of the present invention, it is preferable that the solvent (C) is contained in an amount of 20 to 5,000 parts by mass, further 60 to 1,000 parts by mass based on 100 parts by mass of the curable fluorine-containing resin (A), and the curing agent (B) is blended in an equivalent ratio of 0.5 to 1.5, further 0.8 to 1.2 to the cure site of the curable fluorine-containing resin (A).

In the composition of the present invention, various additives can be blended unless transparency, adhesion and weather resistance are impaired. Examples of the additives are, for instance, a surface hydrophilization agent, a thermal insulation agent, an ultraviolet absorber, a coupling agent (silane type or metallic type), an antioxidant, a pigment, a filler, a defoaming agent, a thickener, a leveling agent, a curing accelerator, a filler, an antigelling agent, and the like.

A surface hydrophilization agent is an additive for making a surface of a coating film hydrophilic, and exhibits an effect of preventing staining due to rainfall. Examples of preferable surface hydrophilization agent are, for instance, those disclosed in WO96/26254 and especially from the viewpoint of satisfactory migration to a surface and good property for preventing staining due to rainfall, the following compounds are preferable. Acryl silicates or fluorine-containing alkyl silicates represented by the formula: 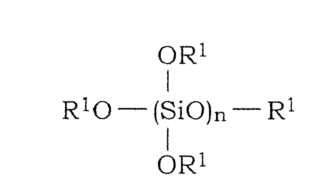 wherein n is an integer of 1 to 20, R¹s are all different from each other or at least two of them are the same, and each is a monovalent organic group which has 1 to 1,000 carbon atoms and may contain oxygen atom, nitrogen atom and/or silicon atom and a part or the whole of hydrogen atoms of the organic group may be substituted by fluorine atom or fluorine atom and chlorine atom, and oligomers thereof.

Among these, from the viewpoint of satisfactory migration to a surface and good property for preventing staining due to rainfall, preferable are those in which a part or the whole of hydrogen atoms of R¹ are substituted by fluorine atoms. Examples of R¹ are F(CF₂)ₙ(CH₂)ₘ, (CF₃)₂CH, H(CF₂)ₙ(CH₂)ₘ, F(CF₂)ₙCHFCF₂(CH₂)ₘ, F(CF₂)ₙ(CH₂)ₘC=O, H(CF₂)ₙ(CH₂)ₘC=O, (F(CF₂)ₙ(CH₂)ₘ)₂N, (H(CF3)2C)2N, (H(CF2)n(CH2)m)2N, F(CF₂)ₙO(CF(CF₃)CF₂O)ₘCF(CF₃)C=O, and the like (m is 0 or an integer of 1 to 6, n is an integer of 1 to 10).

An adding amount is preferably 0 to 100 parts by mass, further preferably 0.1 to 50 parts by mass, especially preferably 1 to 20 parts by mass based on 100 parts by mass of the curable fluorine-containing resin (A).

A thermal insulation agent is an additive for preventing temperature beneath a coating film (substrate and the like) from increasing by reflecting or absorbing infrared rays of sunlight, and exhibits an effect of decreasing the inside temperature. Examples of preferable thermal insulation agents are, for instance, those disclosed in JP6-19061B, JP10-120946A, JP2000-72484A and JP2004-204173A, and antimony-doped tin oxide (ATO), tin-doped indium oxide (ITO), aluminum-doped zinc oxide (AZO), titanium oxide and cerium oxide are preferable especially from the viewpoint of visible light transmittance.

An adding amount thereof is preferably 0 to 100 parts by mass, further preferably 0.1 to 20 parts by mass, especially preferably 0.2 to 10 parts by mass based on 100 parts by mass of the curable fluorine-containing resin (A).

An ultraviolet absorber may be blended in order to prevent deterioration of a coating film due to absorption of ultraviolet rays of sunlight. Examples thereof are benzophenone, benzotriazole, triazine, benzoate, salicylate, cyanoacrylate, nickel complex and oxalic anilide ultraviolet absorbers.

Exemplified below are various commercially available ultraviolet absorbers (trade names). Examples are not limited to those exemplified below, and they may be used in combination.
Benzophenone ultraviolet absorbers:
Uvinul 3049 and Uvinul 3050 (all available from BASF Japan Co., Ltd.); SUMISORB 110, SUMISORB 130 and SUMISORB 200 (all available from Sumitomo Chemical Industry Co., Ltd.)
Benzotriazole ultraviolet absorbers:
Tinuvin 900, Tinuvin PS, Tinuvin 384, Tinuvin 109, Tinuvin 928 and Tinuvin 1130 (all available from Ciba Specialty Chemicals Co., Ltd.); SUMISORB 250, SUMISORB 300, SUMISORB 320, SUMISORB 340 and SUMISORB 350 (all available from Sumitomo Chemical Industry Co., Ltd); ADEKASTAB LA-32 and ADEKASTAB LA-31 (all available from ADEKA CORPORATION)
Triazine ultraviolet absorbers:
Tinuvin 400, Tinuvin 405 and Tinuvin 479 (all available from Ciba Specialty Chemicals Co., Ltd.)
Benzoate ultraviolet absorbers:
SUMISORB 400 (available from Sumitomo Chemical Industry Co., Ltd.)
Cyanoacrylate ultraviolet absorbers:
Uvinul 3055 and Uvinul 3039 (available from BASF Japan Co., Ltd.)
Other ultraviolet absorbers:
Propanedioic acid, [(4-methoxyphenyl)methylene]-, dimethyl ester
By electing an ultraviolet absorber properly, yellowing can be inhibited efficiently even in long-term exposing.

From this point of view, benzotriazole, triazine and cyanoacrylate ultraviolet absorbers having capability of absorbing ultraviolet rays in long wavelength region are preferable, and triazine ultraviolet absorbers especially having excellent capability of absorbing ultraviolet rays are preferable.

An adding amount thereof is preferably 0 to 50 parts by mass, further preferably 0.5 to 10 parts by mass, especially preferably 1 to 5 parts by mass based on 100 parts by mass of the curable fluorine-containing resin (A).

A coupling agent has an effect of improving adhesion to the transparent resin layer (substrate). Examples of a silane coupling agent are, for instance, those having epoxy group, amino group, isocyanate group, mercapto group or (meth)acrylate group, and specifically there are γ-glycidoxypropyltrimethoxysilane, β-(3,4-epoxycyclohexyl)ethyltrimethoxysilane, γ-aminopropyltriethoxysilane, γ-methacryloxypropyltrimethoxysilane, γ-mercaptopropyltriethoxysilane, OCNC₃H₆Si(OCH₃)₃, and the like. Examples of metallic coupling agents are, for instance, aluminum coupling agents and titanium coupling agents, and specifically there are aluminum isopropylate, aluminum ethoxide, ethyl acetoacetate aluminum diisoprolylate, aluminum tris(ethyl acetoacetate), alkyl acetoacetate aluminum diisoprolylate, aluminum monoacetylacetonatebis(ethylacetoacetate), aluminum tris(acetylacetonate), cyclic aluminum oxide isopropylate, titanium chelate, and the like.

Among these, epoxy-containing silane coupling agents are preferable from the viewpoint of coloring property and adhesion.

An adding amount thereof is preferably 0 to 30 parts by mass, further preferably 0.1 to 10 parts by mass, especially preferably 1 to 10 parts by mass based on 100 parts by mass of the curable fluorine-containing resin (A).

Various kinds of antioxidants can be used as an antioxidant, and there can be exemplified, for instance, hindered amine, phenol, phosphite and vitamin E antioxidants.

An adding amount thereof is preferably 0 to 20 parts by mass, further preferably 0.5 to 5 parts by mass, especially preferably 1 to 3 parts by mass based on 100 parts by mass of the curable fluorine-containing resin (A).

The curable fluorine-containing resin composition of the present invention can be prepared by a usual mixing method using a mixer, a roll mill or the like. In addition, the composition may be a so-called two component coating composition to be used by mixing a curable fluorine-containing resin and a curing agent just before coating, depending on kind of a curable fluorine-containing resin.

Such a curable fluorine-containing resin composition is coated on the transparent resin layer (substrate) (II) constituting a protection cover of solar cell.

The transparent resin forming the transparent resin layer (substrate) (II) is preferably a resin having light transmittance of not less than 80 %, further not less than 85 %, especially not less than 90 % measured by the method explained infra.

Specifically there are polycarbonate, polyethylene terephthalate, acrylic resin, polyethylene, polypropylene, polystyrene, polyimide, epoxy resin, and the like. Among these, from the viewpoint of good strength and transparency, polycarbonate, polyethylene terephthalate, acrylic resin, polyimide and fluorine-containing resin are preferable, and further, polycarbonate and acrylic resin are preferable, especially polycarbonate is preferable.

It is known that polycarbonate is excellent in transparency and has satisfactory mechanical characteristics such as hardness, applicability to general purposes and processability, but is inferior in scratch resistance and weather resistance. In addition, since polycarbonate is softened around 150°C of a glass transition point, resins requiring high temperature baking are not applicable to polycarbonate from the viewpoint of heat resistance. However the curable fluorine-containing resin used for the coating composition of the present invention is curable even at normal temperature, and therefore, there is no problem even when applied to polycarbonate.

When it is necessary to consider adhesion and solvent impermeability, a primer layer explained infra may be formed.

In addition, various additives exemplified in the explanation of the top coat layer (III) may be added to the transparent resin layer (substrate) (II) (excluding a surface hydrophilization agent and a leveling agent which modify surface characteristics). Especially addition of a thermal insulation agent, an ultraviolet absorber and an antioxidant is effective. Adding amounts thereof may be within a range mentioned supra. These additives may be added only to the transparent resin layer (II) or may be added to both of the transparent resin layer (II) and the top coat layer (III). Further, kind of additives may be the same or different between the transparent resin layer (II) and the top coat layer (III).

For forming the layer of a cured fluorine-containing resin as the top coat layer (III), there can be employed (1) a method of coating directly on the transparent resin layer (substrate) (II) and then curing; or (2) a method of forming the primer layer (IV) on the transparent resin layer (substrate) (II) and coating directly on this primer layer (IV) and then curing.

In the direct coating method (1), it is necessary that the solvent (C) used in the curable fluorine-containing coating composition of the present invention is one comprising only a solvent not attacking the transparent resin of the transparent resin layer (substrate) (II) or is a solvent mixture comprising a solvent not attacking the transparent resin as a main solvent. Suitable example of such a solvent not attacking the transparent resin is single use of the above-mentioned weak solvents or a solvent mixture thereof, though it depends on kind of the transparent resin. When the transparent resin is polycarbonate, polyester or acrylic resin, for example, at least one of nonpolar hydrocarbon solvents, especially 3rd class organic solvents is preferable. Examples of other solvent which can be mixed are solvents explained infra other than weak solvents, and such a solvent is mixed in such an amount as not to impair transparency of the transparent resin.

In the method (2) of using the primer layer (IV), since permeation of a solvent into the transparent resin can be prevented by the primer layer (IV), a solvent which may somewhat attack the transparent resin, for example a polar organic solvent may be contained in the curable fluorine-containing coating composition.

In this case, for example, an acrylic resin, a urethane resin, a polyester resin or a fluorine-containing resin can be suitably used as a primer.

In any of the methods, coating can be carried out by a usual method such as dipping, casting, roll coating, curtain flow coating, bar coating, spray coating or spin coating, and also, curing methods such as cold curing, drying by baking and UV curing can be employed. Curing conditions varies depending on a curing system, and known curing conditions can be used.

The present invention also relates to the solar cell comprising the solar cell module (I), the transparent resin layer (II) provided on the sunlight irradiation side of the module and the top coat layer (III) provided on the transparent resin layer directly or via the primer layer (IV), in which the top coat layer (III) is a cured layer of the above-mentioned coating composition for a protection cover.

Further, the present invention relates to the laminated film for a protection cover of solar cell comprising the transparent resin layer (II) and the top coat layer (III) provided on the transparent resin layer directly or via the primer layer (IV) and being provided on the sunlight irradiation side of the solar cell module (I), in which the top coat layer (III) is a cured layer of the above-mentioned curable fluorine-containing coating composition.

There can be used known modules comprising a solar cell sealed with a sealing agent and a back sheet without specific limitation, as the solar cell module (I).

The transparent resin layer (substrate) (II) may be formed by coating directly on the solar cell, or may be formed by previously preparing a laminated film for a protection cover having, thereon, the top coat layer (III) of a cured fluorine-containing coating composition and then adhering this laminated film to the solar cell module (I).

The thickness of the transparent resin layer (substrate) (II) varies depending on kind and transparency of the resin, and is preferably within a range usually from 50 µm to 15 mm.

The thickness of the top coat layer (III) varies depending on kind of the curable fluorine-containing resin and kind of the transparent resin substrate, and is preferably within a range usually from 1 to 500 µm.

When the primer layer (IV) is provided, the thickness of the primer layer varies depending on kind of the primer and kind of the transparent resin substrate, and is preferably within a range usually from 0.1 to 100 µm.

The preferable embodiments of the present invention are then explained below, and the present invention is not limited to them.
(Embodiment 1)
   (II) Transparent resin:
      Polycarbonate
   (III) Top coat layer:
      Cured article of the following curable fluorine-containing coating composition
         (A) Curable fluorine-containing resin:
            Curable fluorine-containing resin (A1) mentioned supra (especially a copolymer comprising TFE, vinyl ester and a monomer having cure site (hydroxyl or carboxyl))
         (B) Curing agent:
            Isocyanate curing agent
         (C) Solvent:
            3rd class organic solvent (especially coal tar naphtha) (D) Additives:
               Hydrophilization agent, ultraviolet absorber, silane coupling agent
   (IV) Primer layer:
      None
(Embodiment 2)
   (II) Transparent resin:
      Polyethylene terephthalate
   (III) Top coat layer:
      Cured article of the following curable fluorine-containing coating composition
         (A) Curable fluorine-containing resin:
            Curable fluorine-containing resin (A1) mentioned supra (especially a copolymer comprising CTFE, vinyl ether and a monomer having cure site (hydroxyl or carboxyl))
         (B) Curing agent:
            Isocyanate curing agent
         (C) Solvent:
            3rd class organic solvent (especially mineral spirit) (D) Additives:
               Silane coupling agent, ultraviolet absorber (IV) Primer layer:
                  None
(Embodiment 3)
   (II) Transparent resin:
      Acrylic resin
   (III) Top coat layer:
      Cured article of the following curable fluorine-containing coating composition
         (A) Curable fluorine-containing resin:
            Curable fluorine-containing resin (A1) mentioned supra (especially a mixture of a copolymer comprising TFE, vinyl ester and a monomer having cure site (hydroxyl or carboxyl) and a curable acrylic resin)
         (B) Curing agent:
            Isocyanate curing agent
         (C) Solvent:
            3rd class organic solvent (especially coal tar naphtha)
         (D) Additive:
            Ultraviolet absorber
   (IV) Primer layer:
      None
(Embodiment 4)
   (II) Transparent resin:
      Polycarbonate
   (III) Top coat layer:
      Cured article of the following curable fluorine-containing coating composition
         (A) Curable fluorine-containing resin:
            Curable fluorine-containing resin (A2) mentioned supra (curable fluorine-containing resin being soluble in butyl acetate and represented by a copolymer comprising TFE, hydrocarbon monomer, vinyl ester and a monomer having cure site (hydroxyl or carboxyl))
         (B) Curing agent:
            Isocyanate curing agent
         (C) Solvent:
            Butyl acetate
         (D) Additives:
            Ultraviolet absorber, hydrophilization agent (IV) Primer layer:
               To be formed (non-curable acrylic resin)
(Embodiment 5)
   (II) Transparent resin:
      Polycarbonate
   (III) Top coat layer:
      Cured article of the following curable fluorine-containing coating composition
         (A) Curable fluorine-containing resin:
            Curable fluorine-containing resin (A2) mentioned supra (curable fluorine-containing resin being soluble in butyl acetate and represented by a copolymer comprising TFE, hydrocarbon monomer, vinyl ester and a monomer having cure site (hydroxyl or carboxyl))
         (B) Curing agent:
            Isocyanate curing agent
         (C) Solvent:
            Butyl acetate
         (D) Additives:
            Ultraviolet absorber, hydrophilization agent
   (IV) Primer layer:
      To be formed (UV-curable acrylic resin)
      The coating composition of the present invention is suitable for a protection cover of solar cell, and in addition, the same effect as in the present invention can be obtained even if it is applied to articles used in the same environment as in a protection cover of solar cell. Examples of such articles are, for instance, windows and lighting portion of building, automobile, train and airplane; roof of building and car park; soundproof wall and wind-shielding of road; light cover for automobile and motorcycle; protection covers for various illuminations, and the like.

### EXAMPLE

The present invention is then explained by means of examples, but the present invention is not limited to them.

Methods of measurement employed in the present invention are as follows.

### (NMR analysis)

NMR measuring equipment: available from BRUKER
¹H-NMR measuring conditions: 300 MHz (tetramethylsilane=0 ppm)
¹⁹F-NMR measuring conditions: 282 MHz (trichlorofluoromethane=0 ppm)

### (Elemental analysis)

Measuring device: CHN CORDER available from Jay Science Kabushiki Kaisha and Ion Analyzer 901 available from Orion Research Kabushiki Kaisha

### (Hydroxyl value and acid value)

Calculated from composition obtained by NMR and elemental analysis

### (Number average molecular weight)

Measuring device: GPC available from Toso Kabushiki Kaisha (Model HLC-8020)
Measuring conditions: Three TSKgel: GMHXL, one G2500HXL and one GRCXL-L are used as columns. Tetrahydrofuran is used as an eluent, and polystyrene, a molecular weight of which is known, is used as a reference sample.

### (Glass transition temperature Tg)

Tg is determined at 2nd run by a mid-point method using a DSC measuring equipment 7 Series available from Perkin Elmer Co., Ltd. according to ASTM E1356-98.

Measuring conditions
Temperature elevating rate: 10°C/min
Amount of sample: 10 mg
Heat cycle: from 25° to 150°C, heating, cooling, heating

### (Solubility test)

"Soluble in an organic solvent" means that 10 g or more is dissolved in 100 g of an organic solvent at 20±5°C (a solution turns transparent). It is preferable that 100 g or more is dissolved in 100 g of an organic solvent, since preparation and coating of a coating composition are easy.

### (Measurement of light transmittance and Haze value)

Measurement is carried out using Haze Guard II available from Kabushiki Kaisha Toyo Seiki Seisakusho according to ASTM D1003.

### PREPARATION EXAMPLE 1

### (Preparation of curable fluorine-containing copolymer)

Into a 6,000 ml stainless steel autoclave were poured 2,500 parts by mass of butyl acetate, 554.5 parts by mass of VEOVA9 (hereinafter referred to as "VV9"), 69.1 parts by mass of vinyl benzoate (VBz) and 83.5 parts by mass of 4-hydroxybutylvinyl ether (HBVE), and the inside of the autoclave was cooled to 5°C, and evacuation and replacement of the inside of the autoclave with nitrogen gas were repeated three times. Lastly, the autoclave was evacuated again, and 280.0 parts by mass of tetrafluoroethylene (TFE) was poured therein. The inside temperature of the autoclave was increased to 62.0°C with stirring, and 28.38 parts by mass of PERBUTYL PV (trade name of a peroxide-based polymerization initiator available from NOF CORPORATION) was charged to initiate polymerization. The reaction was stopped when the pressure inside a reactor decreased from 1.0 MPaG to 0.4 MPaG. Yield of polymerization was 98.0 %. As a result of ¹⁹F-NMR, ¹H-NMR and elemental analysis, the obtained fluorine-containing copolymer was a fluorine-containing copolymer (1-1) comprising 37 % by mole of TFE, 45.2 % by mole of VV9, 7.0 % by mole of VBz and 10.8 % by mole of HBVE, and a number average molecular weight Mn thereof was 9.0 × 1,000. The glass transition temperature Tg was 30°C. Solubility in a solvent (coal tar naphtha and mineral spirit) was "soluble".

Further, a fluorine-containing copolymer (1-2) having hydroxyl group was prepared in the same manner as above except that the monomers shown in Table 1 were used. Composition, number average molecular weight Mn, hydroxyl value and solubility in solvents (coal tar naphtha and mineral spirit) are shown in Table 1.

**TABLE 1**

| | | Production number | |
|---|---|---|---|
| | | 1-1 | 1-2 |
| Composition of copolymer (part by mass) | | | |
| | TFE | 280.0 | - |
| | CTFE | - | 300.0 |
| | VV9 | 554.5 | - |
| | CHVE | - | 216.1 |
| | VBz | 69.1 | - |
| | nBVE | - | 41.2 |
| | HBVE | 83.5 | 41.8 |
| Hydroxyl value (mgKOH/g) | | 42 | 34 |
| Acid value (mgKOH/g) | | 0 | 0 |
| Total (mgKOH/g) | | 42 | 34 |
| Number average molecular weight Mn (×1,000) | | 9.0 | 8.6 |

| Solubility in solvent | | | |
|---|---|---|---|
| | Coal tar naphtha | Soluble | Soluble |
| | Mineral spirit | Soluble | Soluble |

### EXAMPLE 1

100 parts by mass of the curable fluorine-containing copolymer (1-1) was dissolved in 100 parts by mass of coal tar naphtha to prepare a solution having a solid content of 50 % by mass. Into 200 parts by mass of this solution were poured 15.3 parts by mass of DURANATE TSA-100 (trade name, isocyanate curing agent available from Asahi Kasei Corporation), 4.0 parts by mass of Uvinul 3039 (trade name, ultraviolet absorber available from BASF), 10.0 parts by mass of γ-glycidoxypropyltriethoxysilane as a coupling agent and 50 parts by mass of coal tar naphtha as an additional solvent, followed by sufficient mixing to prepare a coating composition.

### EXAMPLE 2

100 parts by mass of the curable fluorine-containing copolymer (1-2) was dissolved in 100 parts by mass of mineral spirit to prepare a solution having a solid content of 50 % by mass. Into 200 parts by mass of this solution were poured 12.4 parts by mass of DURANATE TSA-100, 4.0 parts by mass of Uvinul 3039, 10.0 parts by mass of γ-glycidoxypropyltriethoxysilane and 50 parts by mass of mineral spirit as an additional solvent, followed by sufficient mixing to prepare a coating composition.

### EXAMPLE 3

100 parts by mass of the curable fluorine-containing copolymer (1-1) was dissolved in 100 parts by mass of coal tar naphtha to prepare a solution having a solid content of 50 % by mass. Into 200 parts by mass of this solution were poured 15.3 parts by mass of DURANATE TSA-100, 4.0 parts by mass of Uvinul 3039, 10.0 parts by mass of γ-glycidoxypropyltriethoxysilane, 5 parts by mass of ZEFFLE GH700 (trade name, a hydrophilization agent available from DAIKIN INDUSTRIES, LTD., fluorine-containing alkyl silicate) and 50 parts by mass of coal tar naphtha as an additional solvent, followed by sufficient mixing to prepare a coating composition.

### EXAMPLE 4

50 parts by mass of the curable fluorine-containing copolymer (1-1) and 50 parts by mass of an acrylic resin (a copolymer comprising methyl methacrylate, cyclohexyl methacrylate, 2-ethylhexyl acrylate and 2-hydroxyethyl methacrylate) were dissolved in 100 parts by mass of coal tar naphtha to prepare a transparent solution having a solid content of 50 % by mass.

Into 200 parts by mass of this solution were poured 15.3 parts by mass of DURANATE TSA-100, 4.0 parts by mass of Uvinul 3039, 5 parts by mass of ZEFFLE GH700 and 50 parts by mass of coal tar naphtha as an additional solvent, followed by sufficient mixing to prepare a coating composition.

### EXAMPLE 5

100 parts by mass of the curable fluorine-containing copolymer (1-1) was dissolved in 100 parts by mass of coal tar naphtha to prepare a solution having a solid content of 50 % by mass. Into 200 parts by mass of this solution were poured 15.3 parts by mass of DURANATE TSA-100, 4.0 parts by mass of Uvinul 3039, 5.0 parts by mass of ZEFFLE GH700 and 50 parts by mass of coal tar naphtha as an additional solvent, followed by sufficient mixing to prepare a coating composition.

### EXAMPLE 6

Into 200 parts by mass of a solution of a curable fluorine-containing TFE resin (ZEFFLE GK510 (trade name) available from DAIKIN INDUSTRIES, LTD., solid content: 50 % by mass, solvent: butyl acetate, hydroxyl value: 60 mgKOH/g, acid value: 9 mgKOH/g, a curable fluorine-containing copolymer 1-3) were poured 21.0 parts by mass of SUMIJULE N3300 (trade name, an isocyanate curing agent available from Sumika Bayer Urethane Co., Ltd.), 4.0 parts by mass of Uvinul 3039 and 50 parts by mass of butyl acetate as an additional solvent, followed by sufficient mixing to prepare a coating composition.

### EXAMPLE 7

Into 154 parts by mass of a solution of a curable fluorine-containing TFE resin (ZEFFLE GK570 (trade name) available from DAIKIN INDUSTRIES, LTD., solid content: 65 % by mass, solvent: butyl acetate, hydroxyl value: 60 mgKOH/g, acid value: 3 mgKOH/g, a curable fluorine-containing copolymer 1-4) were poured 20.6 parts by mass of SUMIJULE N3300, 4.0 parts by mass of Uvinul 3039, 5.0 parts by mass of ZEFFLE GH700 and 96 parts by mass of butyl acetate as an additional solvent, followed by sufficient mixing to prepare a coating composition.

### EXAMPLE 8

60 parts by mass of a non-curable fluorine-containing VdF resin (ZEFFLE LC700 (trade name) available from DAIKIN INDUSTRIES, LTD., a VdF/TFE/CTFE copolymer, a curable fluorine-containing copolymer 1-5) and 40 parts by mass of an acrylic resin (a copolymer comprising methyl methacrylate, cyclohexyl methacrylate, 2-ethylhexyl acrylate and 2-hydroxyethyl methacrylate) were dissolved in 100 parts by mass of coal tar naphtha to prepare a transparent solution having a solid content of 50 % by mass.

Into 100 parts by mass of this solution were poured 5.8 parts by mass of SUMIJULE N3300, 4.0 parts by mass of Uvinul 3039 and 5.0 parts by mass of ZEFFLE GH700, followed by sufficient mixing to prepare a coating composition.

### EXAMPLES 9 to 12 and COMPARATIVE EXAMPLE 1

After degreasing of a surface of a polycarbonate film (Iupilon film FE-2000 (trade name) available from Mitsubishi Engineering-Plastics Corporation, thickness: 100 µm), the respective coating compositions prepared in Examples 1 to 5 were coated thereon by air spray coating to give a dried coating film having a thickness of 50 µm. Then the coating film was heated at 80°C for 20 minutes for drying and curing to prepare laminated films for a protection cover.

Light transmittance, Haze value and appearance before testing, light transmittance, Haze value and appearance after accelerated weather resistance test, light transmittance and Haze value after moisture resistance test, adhesion, staining by exposure and solvent resistance were evaluated, using the prepared laminated films for a protection cover. The results are shown in Table 2. In Table 2, a film used in Comparative Example 1 is a polycarbonate film having no top coat layer of the present invention.

### (Appearance)

To be evaluated with naked eyes.

### (Accelerated weather resistance test)

An accelerated weather resistance test is continued for 200 hours using SUPER UV Tester Model W13 (trade name, weather resistance tester available from IWASAKI ELECTRIC CO., LTD.). Test conditions are light irradiation of 11 hours (illumination: 100 mW/cm², black panel temperature: 63°C, relative humidity: 70 %), dewing of 11 hours (illumination: 0 mW/cm², black panel temperature: room temperature, relative humidity: 100 %), and resting of 1 hour (illumination: 0 mW/cm², black panel temperature: 63°C, relative humidity: 85 %).

### (Moisture resistance test)

A test plate is hung in a thermo-hygrostat LH-20-01La (NAGANO SCIENCE CO., LTD.) set at 80°C of an atmosphere temperature and 85 % of a humidity, and a test is continued for 1,000 hours. Light transmittance and Haze value are measured before and after the test.

### (Adhesion)

A cross-cut test is carried out according to JIS K5400.

### (Staining by exposure)

A test plate is set on an exposure rack at an angle of 30° being faced toward southern direction on a roof of 4-storied building located in an industrial zone in Osaka Prefecture to carry out an exposure test. The test plate is exposed for one month. Then lightness (L*) of the test plate is measured, and a difference (-ΔL*) between an initial lightness and a lightness after the exposure is evaluated.

### (Solvent resistance)

A surface condition of a coating film after rubbing it 100 times with a cotton cloth impregnated with butyl acetate is evaluated with naked eyes by the following criteria.
A: There is no abnormal change.
B: Gloss is somewhat faded.
C: There are melting, swelling and remarkable fading of gloss of a coating film.

### EXAMPLE 13

A top coat layer was formed and a laminated film was prepared in the same manner as in Example 9 except that an acrylic resin plate (acrylic resin plate available from Nippon Testpanel Co., Ltd., thickness: 1 mm) was used as a transparent resin substrate instead of a polycarbonate film, and the composition of Example 5 was used as a coating composition.

Physical properties of the prepared laminated film for a protection cover were evaluated in the same manner as in Example 9. The results are shown in Table 2.

**TABLE 2 "**

| | | | Example | | | | | Com. Ex. |
|---|---|---|---|---|---|---|---|---|
| | | | 9 | 10 | 11 | 12 | 13 | 1 |
| Coating composition (part by mass) | | | | | | | | |
| | | | Ex. 1 | Ex. 2 | Ex. 3 | Ex. 4 | Ex. 5 | Nil |
| | Curable fluorine-containing resin (A) | | | | | | | |
| | | 1-1 | 100 | | 100 | 50 | 100 | |
| | | 1-2 | | 100 | | | | |
| | | Acrylic resin | | | | 50 | | |
| | Curing agent (B) | | | | | | | |
| | | TSA-100 | 15.3 | 12.4 | 15.3 | 15.3 | 15.3 | |
| | Solvent (C) | | | | | | | |
| | | Coal tar naphtha | 100 | | 100 | 100 | 100 | |
| | | Mineral spirit | | 100 | | | | |
| | Additional solvent | | | | | | | |
| | | Coal tar naphtha | 50 | | 50 | 50 | 50 | |
| | | Mineral spirit | | 50 | | | | |
| | Additive | | | | | | | |
| | | Ultraviolet absorber | 4 | 4 | 4 | 4 | 4 | |
| | | Hydrophilization agent | | | 5 | 5 | 5 | |
| | | Coupling agent | 10 | 10 | 10 | | | |
| Transparent resin substrate | | | | | | | | |
| | Polycarbonate | | ○ | ○ | ○ | ○ | | ○ (uncoated) |
| | Acrylic resin | | | | | | ○ | |
| Physical properties | | | | | | | | |
| | Light transmittance | | | | | | | |
| | | before test | 92.5 | 92.6 | 92.9 | 92.0 | 92.8 | 91.7 |
| | | after accelerated weather resistance test | 92.3 | 90.0 | 92.3 | 91.5 | 92.1 | 83.0 |
| | | after moisture resistance test | 92.4 | 92.6 | 92.7 | 91.8 | 92.7 | 91.5 |
| | Haze value | | | | | | | |
| | | before test | 0.82 | 0.92 | 0.82 | 0.70 | 0.80 | 0.32 |
| | | after accelerated weather resistance test | 0.87 | 10.0 | 1.15 | 1.81 | 1.23 | 50.80 |
| | | after moisture resistance test | 0.92 | 1.12 | 0.95 | 0.80 | 0.93 | 2.30 |
| | Appearance | | | | | | | |
| | | before test | no abnormal change | no abnormal change | no abnormal change | no abnormal change | no abnormal change | no abnormal change |
| | | after accelerated weather resistance test | no abnormal change | slight yellowing | no abnormal change | no abnormal change | no abnormal change | yellowing |
| | Adhesion | | no peeling | no peeling | no peeling | no peeling | no peeling | no peeling |
| | Staining by exposure (-ΔL*: 1 month) | | 5.3 | 5.5 | 1.9 | 2.1 | 2.2 | 5.7 |
| | Solvent resistance | | A | A | A | A | A | C |

### EXAMPLES 14 to 16 and COMPARATIVE EXAMPLE 2

After degreasing of a surface of a polycarbonate film (Iupilon film FE-2000 (trade name) available from Mitsubishi Engineering-Plastics Corporation, thickness: 100 µm), an acrylic resin primer (a solution of 20 parts by mass of a methyl methacrylate / ethyl acrylate/methacrylic acid copolymer (number average molecular weight: 40,000, Tg: 45°C, acid value: 12 mgKOH/g) in a solvent mixture of 56 parts by mass of isopropanol and 24 parts by mass of n-propyl acetate) was coated on the polycarbonate film using a bar coater #18 (available from Yasuda-Seiki-Seisakusho, Ltd.) to give a dried coating film having a thickness of 5 µm. Then the coating film was heated at 80°C for 20 minutes to form a primer layer.

The respective coating compositions prepared in Examples 6 to 8 were coated on this primer layer by air spray coating to give a dried coating film having a thickness of 50 µm. Then the coating film was heated at 80°C for 20 minutes for drying and curing to prepare laminated films for a protection cover.

Physical properties of the prepared laminated films for a protection cover were evaluated in the same manner as in Example 9. The results are shown in Table 3. In Table 3, a film used in Comparative Example 2 is a laminated film prepared by coating the coating composition of Example 6 directly on a polycarbonate film without providing a primer layer.

**TABLE 3**

| | | | Example | | | Com. Ex. |
|---|---|---|---|---|---|---|
| | | | 14 | 15 | 16 | 2 |
| Coating composition (part by mass) | | | | | | |
| | | | Ex. 6 | Ex. 7 | Ex. 8 | Ex. 6 |
| | Curable fluorine-containing resin (A) | | | | | |
| | | 1-3 | 100 | | | 100 |
| | | 1-4 | | 100 | | |
| | | 1-5 | | | 60 | |
| | | Acrylic resin | | | 40 | |
| | Curing agent (B) | | | | | |
| | | SUMIJULE N3300 | 21 | 20.6 | 5.8 | 21 |
| | Solvent (C) | | | | | |
| | | Butyl acetate | 100 | 100 | | 100 |
| | | Coal tar naphtha | | | 100 | |
| | Additional solvent | | | | | |
| | | Butyl acetate | 50 | 96 | | 50 |
| | Additive | | | | | |
| | | Ultraviolet absorber | 4 | 4 | 4 | 4 |
| | | Hydrophilization agent | | 5 | 5 | |
| Transparent resin substrate | | | | | | |
| | Polycarbonate | | ○ | ○ | ○ | ○ |
| Primer layer | | | | | | |
| | Acrylic primer | | ○ | ○ | ○ | × |
| Physical properties | | | | | | |
| | Light transmittance | | | | | |
| | | before test | 92.6 | 92.7 | 92 | 89.5 |
| | | after accelerated weather resistance test | 92 | 92.3 | 91.2 | 88.3 |
| | | after moisture resistance test | 92.5 | 92.6 | 92 | 88.7 |
| | Haze value | | | | | |
| | | before test | 0.52 | 0.82 | 0.95 | 66.6 |
| | | after accelerated weather resistance test | 0.82 | 1.2 | 2.3 | 68.10 |
| | | after moisture resistance test | 0.75 | 0.97 | 1.05 | 68.70 |
| | Appearance | | | | | |
| | | before test | no abnormal change | no abnormal change | no abnormal change | turbid in white |
| | | after accelerated weather resistance test | no abnormal change | no abnormal change | no abnormal change | turbid in white |
| | Adhesion | | no peeling | no peeling | no peeling | peeling |
| | Staining by exposure (-ΔL*: 1 month) | | 5.2 | 2.3 | 2.3 | 5.5 |
| | Solvent resistance | | A | A | A | A |

### EXAMPLE 17

Into 154 parts by mass of a solution of a curable fluorine-containing TFE resin (ZEFFLE GK570 (trade name) available from DAIKIN INDUSTRIES, LTD., a curable fluorine-containing copolymer 1-4) were poured 20.6 parts by mass of SUMIJULE N3300, 2.0 parts by mass of Tinuvin 479 (triazine ultraviolet absorber available from Ciba Specialty Chemicals Inc.), 2.0 parts by mass of Tinuvin 400 (triazine ultraviolet absorber available from Ciba Specialty Chemicals Inc.) and 96 parts by mass of butyl acetate as an additional solvent, followed by sufficient mixing to prepare a coating composition.

### EXAMPLE 18

Into 154 parts by mass of a solution of a curable fluorine-containing TFE resin (ZEFFLE GK570 (trade name) available from DAIKIN INDUSTRIES, LTD., a curable fluorine-containing copolymer 1-4) were poured 20.6 parts by mass of SUMIJULE N3300, 2.0 parts by mass of Tinuvin 479, 2.0 parts by mass of Tinuvin 400, 5.0 parts by mass of ZEFFLE GH700 and 96 parts by mass of butyl acetate as an additional solvent, followed by sufficient mixing to prepare a coating composition.

### EXAMPLES 19 and 20

After degreasing of a surface of a polycarbonate film (Iupilon film FE-2000 (trade name) available from Mitsubishi Engineering-Plastics Corporation, thickness: 100 µm), an acrylic resin primer (a solution of 20 parts by mass of a methyl methacrylate/ethyl acrylate/methacrylic acid copolymer (number average molecular weight: 40,000, Tg: 45°C, acid value: 12 mgKOH/g) in a solvent mixture of 56 parts by mass of isopropanol and 24 parts by mass of n-propyl acetate) was coated on the polycarbonate film using a bar coater #18 (available from Yasuda-Seiki-Seisakusho, Ltd.) to give a dried coating film having a thickness of 5 µm. Then the coating film was heated at 80°C for 20 minutes to form a primer layer.

The respective coating compositions prepared in Examples 17 to 18 were coated on this primer layer by air spray coating to give a dried coating film having a thickness of 50 µm. Then the coating film was heated at 80°C for 20 minutes for drying and curing to prepare laminated films for a protection cover.

Physical properties of the prepared laminated films for a protection cover were evaluated in the same manner as in Example 9. Further, an accelerated weather resistance test was carried out for 500 hours, and a change in appearance was evaluated. The results are shown in Table 4.

**TABLE 4**

| | | | | Example 19 | Example 20 |
|---|---|---|---|---|---|
| Coating composition (part by mass) | | | | | |
| | | | | Ex. 17 | Ex. 18 |
| | Curable fluorine-containing resin (A) | | | | |
| | | 1-4 | | 100 | 100 |
| | Curing agent (B) | | | | |
| | | SUMIJULE N3300 | | 20.6 | 20.6 |
| | Solvent (C) | | | | |
| | | Butyl acetate | | 100 | 100 |
| | Additional solvent | | | | |
| | | Butyl acetate | | 96 | 96 |
| | Additive | | | | |
| | | Ultraviolet absorber | | | |
| | | | Tinuvin 479 | 2 | 2 |
| | | | Tinuvin 400 | 2 | 2 |
| | | Hydrophilization agent | | | 5 |
| Transparent resin substrate | | | | | |
| | Polycarbonate | | | ○ | ○ |
| Primer layer | | | | | |
| | Acrylic primer | | | ○ | ○ |
| Physical properties | | | | | |
| | Light transmittance | | | | |
| | | before test | | 90.3 | 90.2 |
| | | after 200-hour accelerated weather resistance test | | 90.3 | 90.1 |
| | | after moisture resistance test | | 90.2 | 90.1 |
| | Haze value | | | | |
| | | before test | | 1.3 | 1.3 |
| | | after 200-hour accelerated weather resistance test | | 1.5 | 1.6 |
| | | after moisture resistance test | | 1.4 | 1.5 |
| | Appearance | | | | |
| | | before test | | no abnormal change | no abnormal change |
| | | after 200-hour accelerated weather resistance test | | no abnormal change | no abnormal change |
| | | after 500-hour accelerated weather resistance test | | no abnormal change | no abnormal change |
| | Adhesion | | | no peeling | no peeling |
| | Staining by exposure (-ΔL*: 1 month) | | | 5.5 | 2.1 |
| | Solvent resistance | | | A | A |

### INDUSTRIAL APPLICABILITY

According to the present invention, a protection cover of solar cell having processability at room temperature, solvent resistance, weather resistance and durability can be provided without impairing its transparency, and also a curable fluorine-containing coating composition being capable of forming the protection cover can be provided.

## Claims

1. A solar cell comprising
- a solar cell module (I) and,
provided on the sunlight irradiation side of the module (I) in this order,
- a transparent resin layer (II),
- optionally a primer layer (IV), and
- a top coat layer (III) which is a cured layer of a coating composition comprising (A) a curable fluorine-containing resin, (B) a curing agent and (C) a solvent.

2. The solar cell of Claim 1, wherein the curable fluorine-containing resin (A) is a resin (A1) being soluble in a 3rd class organic solvent selected from coal tar naphtha, mineral spirit, turpentine oil, petroleum naphtha, petroleum ether and petroleum benzene.

3. The solar cell of Claim 2, wherein the resin (A1) is a hydroxyl group-containing fluorine-containing copolymer having a hydroxyl value of more than 5 mg KOH/g and a sum of hydroxyl value and acid value of more than 30 mg KOH/g.

4. The solar cell of any of Claims 1-3, wherein the solvent (C) is a non-polar organic hydrocarbon solvent.

5. The solar cell of any of Claims 1-4, wherein the curing agent (B) is an isocyanate curing agent or an amino resin curing agent.

6. The solar cell of any of Claims 1-5, wherein the top coat layer (III) is provided directly on the transparent resin layer (II).

7. The solar cell of any of Claims 1-6, wherein light transmittance of the transparent resin layer (II) is not less than 80 %.

8. The solar cell of any of Claims 1-7, wherein the transparent resin layer (II) is a polycarbonate layer, a polyethylene terephthalate layer or an acrylic resin layer.
